# EUROPÄISCHE PATENTSCHRIFT

(11) **EP 2 819 495 B1**
(45) Veröffentlichungstag und Bekanntmachung des Hinweises auf die Patenterteilung: **11.07.2018**
(21) Anmeldenummer: 14168799.6
(22) Anmeldetag: 19.05.2014
(51) Int. Cl.: H05K 7/14, F24C 15/10

(54) **HALTEEINRICHTUNG FÜR EINE STEUERUNG UND ELEKTROGERÄT**
HOLDING DEVICE FOR A CONTROLLER AND ELECTRIC DEVICE
DISPOSITIF DE FIXATION POUR UNE COMMANDE ET UN APPAREIL ÉLECTRIQUE

(30) Priorität: 17.06.2013 DE 102013211299
(43) Veröffentlichungstag der Anmeldung: 31.12.2014
(73) Patentinhaber: E.G.O. Elektro-Gerätebau GmbH, 75038 Oberderdingen (DE)
(72) Erfinder: Richter, Andreas, 74211 Leingarten (DE)
(74) Vertreter: Patentanwälte Ruff, Wilhelm, Beier, Dauster & Partner mbB

(56) Entgegenhaltungen:
- EP-A1- 2 818 799
- WO-A2-2012/089543

## Beschreibung

### Anwendungsgebiet und Stand der Technik

Die Erfindung betrifft eine Halteeinrichtung für eine Steuerung mit einem Bauteilträger sowie ein damit versehenes Elektrogerät, insbesondere ein Kochfeld.

Um eine Steuerung an einem Elektrogerät, insbesondere einem Kochfeld, anzubringen bzw. zu haltern, wird üblicherweise eine Halteeinrichtung benötigt. Aus der DE 29720772 U1 ist es beispielsweise bekannt, eine Steuerung mit einem Aufbau aus zwei Platinen über einen mehrstufigen Haltezapfen an einer Unterlage bzw. Gehäuseunterseite zu befestigen. Der Haltezapfen kann an der Unterlage bzw. Gehäuseunterseite festgeschraubt werden und trägt dann die beiden Leiterplatten, die jeweils an dem Haltezapfen durch Verrastung befestigt sind.

Aus der WO 2012/089543 A2 ist es bekannt, eine Steuerung mit einer Platine als Bauteilträger durch Rastmittel zu befestigen.

Die nicht-vorveröffentlichte EP 2818799 A1 mit Zeitrang vom 17. Juni 2013 zeigt eine Halteeinrichtung für eine Steuerung mit einem Bauteilträger in Form einer Leiterplatte, der an mehreren Rasthaken an länglichen Rastarmen als Rastmittel gehalten ist.

### Aufgabe und Lösung

Der Erfindung liegt die Aufgabe zugrunde, eine eingangs genannte Halteeinrichtung sowie ein damit versehenes Elektrogerät zu schaffen, mit denen Probleme des Stands der Technik gelöst werden können und es insbesondere möglich ist, eine Steuerung in variabler Hinsicht bzw. mit variabler Position und insbesondere unterschiedliche Steuerungen an derselben Halteeinrichtung bzw. an demselben Elektrogerät zu haltern und so zu befestigen.

Gelöst wird diese Aufgabe durch eine Halteeinrichtung mit den Merkmalen des Anspruchs 1 und durch ein Elektrogerät mit den Merkmalen des Anspruchs 11. Vorteilhafte sowie bevorzugte Ausgestaltungen der Erfindung sind Gegenstand der weiteren Ansprüche und werden im Folgenden näher erläutert. Dabei werden manche der Merkmale nur für die Halteeinrichtung oder nur für das Elektrogerät genannt. Sie sollen jedoch unabhängig davon sowohl für die Halteeinrichtung als auch für das Elektrogerät selbstständig gelten können. Der Wortlaut der Ansprüche wird durch ausdrückliche Bezugnahme zum Inhalt der Beschreibung gemacht.

Es ist vorgesehen, dass die Steuerung einen Bauteilträger aufweist, beispielsweise eine Leiterplatte, alternativ soll darunter aber auch ein Gehäuseteil wie beispielsweise eine Gehäuseseite bzw. Gehäuseunterseite oder -oberseite verstanden werden können. Der Bauteilträger ist formschlüssig an der Halteeinrichtung befestigbar und somit wird die Steuerung oder allgemein eine Baugruppe daran gehaltert und im Elektrogerät festgehalten. Die Halteeinrichtung weist eine Halteplatte oder einen Haltekörper auf, wobei die Halteplatte nicht zwingend plan bzw. eben ausgebildet sein muss. Im Folgenden wird der Begriff "Haltekörper" verwendet, wobei er natürlich auch im Wesentlichen oder vollständig plattenartig ausgebildet sein kann.

An dem Haltekörper sind mindestens zwei Rastmittel zum Festrasten bzw. zum federnden Übergreifen des Bauteilträgers vorgesehen. Eine solche Rastung bzw. Befestigung durch Festrasten weist den Vorteil auf, dass sie werkzeuglos und schnell durchgeführt werden kann und dennoch bei entsprechender Dimensionierung einen ausreichend stabilen Formschluss ergibt.

Erfindungsgemäß ist vorgesehen, dass ein Rastmittel einen Rasthaken mit einem Rastvorsprung daran aufweist, wobei der Rasthaken an einem langen Rastarm des Rastmittels angeordnet ist. Die Rastmittel weisen eine Rastrichtung auf, entlang derer sie zurückweichen beim Festrasten bzw. Anbringen des Bauteilträgers. Nach dem Überfahren des Rastvorsprungs bewegt sich das Rastmittel dann wieder zurück in einer zur Rastrichtung entgegengesetzten Richtung. Ein Rastarm selbst kann einen Längsverlauf haben, der insgesamt und vorteilhaft auch im Wesentlichen in seinem Verlauf einen Winkel von etwa 60° bis 90° zu dieser Rastrichtung aufweist, also bevorzugt in etwa quer oder nahezu quer dazu. Das Rastmittel weist eine Ausgangsposition vor Ansetzen des Bauteilträgers auf, wobei in dieser Ausgangsposition eine vorgesehene Vertiefung im Haltekörper unter dem Rastmittel liegt bzw. das Rastmittel in der Ausgangsposition über dieser Vertiefung ist. Die Vertiefung dient dazu, dass das Rastmittel bzw. der Rastarm und der Rasthaken in sie hinein ausweichen können, vorteilhaft also direkt nach unten in die Vertiefung hinein und somit in einer Richtung rechtwinklig zur Rastrichtung. Dabei kann das Rastmittel, insbesondere der Rasthaken, zumindest teilweise, vorteilhaft weitgehend, in der Vertiefung verschwinden. Durch entsprechende Ausgestaltung der Vertiefung kann vorgesehen sein, dass der Rasthaken dann in dieser vertieften Position bzw. Tiefposition festgeklemmt oder festgehakt bzw. festgerastet ist, so dass er nicht wieder von alleine nach oben zurückbewegt wird. Alternativ kann er nach Entfernen einer ihn hinunterdrückenden Kraft wieder selbsttätig nach oben in die Ausgangsposition zurück fahren. So ist es möglich, dass ein Rastmittel nach unten in die Vertiefung hinein gedrückt wird und aus dem Weg ist.

Vorteilhaft sind in der Rastrichtung gesehen mindestens zwei Rastmittel vorgesehen, die einen Abstand zueinander entlang der Rastrichtung aufweisen bzw. in dieser Richtung versetzt sind. Dies dient ganz offensichtlich zum Befestigen bzw. Haltern von mindestens zwei unterschiedlich großen Steuerungen bzw. Bauteilträgern. Des Weiteren können die Rastmittel auch in einer Richtung quer zur Rastrichtung versetzt zueinander sein, vorteilhaft das in Rastrichtung weiter hinten liegende Rastmittel auch mehr in Richtung einer Außenseite des Bauteilträgers versetzt. Damit kann dem Umstand Rechnung getragen werden, dass längere Steuerungen bzw. Bauteilträger üblicherweise auch breiter sind.

Somit ist es möglich, an ein und derselben Halteeinrichtung mindestens zwei unterschiedlich große Steuerungen bzw. Bauteilträger von Steuerungen zu befestigen bzw. zu haltern. Für jede Größe ist dabei mindestens ein Rastmittel vorgesehen, vorzugsweise zwei erfindungsgemäße Rastmittel, was bedeutet, dass die vorgenannte Anordnung zweifach vorhanden ist. Dabei kann vorgesehen sein, dass zur Halterung einer kleineren Steuerung ein entsprechendes Rastmittel verwendet wird und das andere, benachbarte Rastmittel bleibt unverändert in seiner Ausgangsposition. Wird an derselben Halteeinrichtung eine größere Steuerung gehaltert, so wird das Rastmittel für eine kleinere Steuerung aus seiner Ausgangsposition heraus in die Vertiefung hinein nach unten in die Tiefposition gedrückt und ist somit aus dem Weg ist bzw. es verläuft unterhalb der Steuerung oder kann mit geringem Druck an deren Unterseite anliegen. Die Steuerung bzw. deren Bauteilträger selbst wird dann von dem anderen Rastmittel gehalten. Schließlich kann in weitere Ausgestaltung der Erfindung noch eine dritte Steuerung befestigt werden mit Rastung. Hie für können aber konventionelle Rasthaken vorgesehen sein. Diese dritte Steuerung kann die vorbeschriebenen erfindungsgemäßen Rastmittel überdecken bzw. nach unten in deren Vertiefungen drücken. Vorteilhaft ist dies dann eine sehr große Steuerung.

In vorteilhafter Weiterbildung der Erfindung kann für eine bessere Halterung der Steuerung vorgesehen sein, dass mit seitlichem Abstand zueinander mindestens zwei Rastmittel auf etwa gleicher Höhe in Bezug auf die Rastrichtung vorgesehen sind. Diese beiden Rastmittel dienen dann gleichzeitig zur Halterung einer Steuerung. Vorteilhaft sind sie jeweils näher an einer seitlichen Außenkante des Bauteilträgers oder des Haltekörpers angeordnet als an einer Mittellinie des Haltekörpers entlang der Rastrichtung. Dies bedeutet also, dass sie bei einer angenähert rechteckigen Steuerung mehr in deren Eckbereichen angreifen als in einem mittleren Seitenbereich.

Für diese mindestens zwei Rastarme kann vorteilhaft vorgesehen sein, dass sie bei Anordnung auf etwa gleicher Höhe in Bezug auf die Rastrichtung von einem gemeinsamen Bereich aus weggehen bzw. starten oder abstehen. Dieser gemeinsame Bereich kann in etwa auf einer Mittellängsachse des Bauteilträgers oder des Haltekörpers entlang der Rastrichtung liegen. Damit ist eine symmetrische bzw. ausgeglichene und verteilte Halterung der Steuerung bzw. des Bauteilträgers möglich. Dieser gemeinsame Bereich kann wenige Millimeter breit sein, beispielsweise 3 mm bis 10 oder sogar 15 mm.

In Ausgestaltung der Erfindung kann mit Abstand zu den Rastmitteln entgegen zur Rastrichtung mindestens ein Haltevorsprung vorgesehen sein, um die Steuerung bzw. den Bauteilträger entgegen der Rastrichtung zu haltern, und zwar gegen eine Bewegung weg von den Rastmitteln bzw. gegen eine Bewegung senkrecht zur wesentlichen Fläche oder wesentlichen Ebene des Bauteilträgers, die diesen ansonsten weg von der Halteeinrichtung bzw. dem Haltekörper führen könnte. Ein solcher Haltevorsprung dient zur Halterung einer gegenüberliegenden Seite der Steuerung bzw. des Bauteilträgers an der Halteeinrichtung. Er kann vorteilhaft nicht-rastend ausgebildet sein, so dass die Steuerung bzw. der Bauteilträger von Hand darunter geführt wird und dann durch weiteres Drücken nach unten die Festrastung an den Rastmitteln erfolgt. Vorteilhaft sind zwei Haltevorsprünge vorgesehen, die in etwa auf einer Linie quer zur Rastrichtung der Rastmittel liegen.

Die vorgenannten Vertiefungen zum Ausweichen der Rastmittel können so ausgebildet sein, dass die Rastmittel eben leicht nach unten in sie hineingedrückt oder -bewegt werden können. Dazu können sie sich über die gesamte freigelegte bzw. frei bewegbare Länge der Rastarme erstrecken inklusive der Rasthaken bzw. Rastvorsprünge. Vorteilhaft setzen die Vertiefungen direkt an einem Befestigungsbereich eines Rastmittels bzw. Rastarms am Haltekörper an, insbesondere einem vorgenannten gemeinsamen Bereich für zwei Rastmittel bzw. Rastarme.

Bevorzugt sind die Vertiefungen unter den Rastarmen nur unwesentlich breiter und länger als die Rastarme selbst. Sie können also eine Form aufweisen, die vorteilhaft etwa 5% bis maximal 25% größer ist als die Rastmittel bzw. Rastarme samt Rasthaken von oben. Somit kann ein Rastmittel leicht in diese Vertiefung hineingedrückt werden, ohne ganz exakt treffen zu müssen. Andererseits braucht die Vertiefung nicht unnötig groß zu sein. Die Kontur eines Rastmittels bzw. Rastarms samt Rasthaken von oben kann vorteilhaft der Kontur oder Form der Vertiefung entsprechen, vorteilhaft aber eben 5% bis maximal 25% größer für eine einfache und sichere Einführung.

In weiterer Ausgestaltung der Erfindung ist es möglich, dass in Rastrichtung gesehen weg von dem Bauteilträger bzw. weg von einem vorgenannten Haltevorsprung ein Anschlag an dem Haltekörper vorgesehen ist, der eine Bewegung des Rastmittels bzw. des Rasthakens in Rastrichtung weg von dem Bauteilträger begrenzt. Vorteilhaft kann ein solcher Anschlag im Bereich des Rasthakens bzw. dahinter angeordnet sein. Er dient dazu, dass beim Festrasten des Bauteilträgers das Rastmittel nicht zu stark überbogen wird. Des Weiteren kann er dazu dienen, eine Festrastbewegung definierter durchzuführen. Insbesondere kann vorgesehen sein, dass der Anschlag nur wenige Millimeter, beispielsweise 1 mm bis 10 mm, neben bzw. hinter der Vertiefung angeordnet ist in Rastrichtung gesehen. Somit kann vorgesehen sein, dass das Rastmittel sich nicht mehr über der Vertiefung befindet, wenn ein Bauteilträger entsprechender Größe daran festgerastet werden soll und dazu das Rastmittel in Rastrichtung wegdrückt, beispielsweise um den Bauteilträger mit einem anderen Ende unter einem vorgenannten Haltevorsprung zu führen. Dabei ist vorteilhaft allgemein vorgesehen, dass das Rastmittel in seiner Rastposition zumindest mit dem Rasthaken nicht mehr über der Vertiefung ist, so dass eine Abstützung des Bauteilträgers auch in Richtung auf die Halteeinrichtung zu bzw. nach unten möglich ist.

Für eine definierte Halterung des Bauteilträgers an dem Rastmittel bzw. dem Rasthaken kann mit etwas Abstand unter dem Rastvorsprung ein Abstützvorsprung am Rasthaken selbst bzw. am Rastarm oder allgemein am Rastmittel vorgesehen sein. Dieser Abstand kann 1 mm bis 3 mm betragen, beispielsweise entsprechend einer üblichen Dicke eines Bauteilträgers, insbesondere einer Leiterplatte. Der Abstützvorsprung kann so ausgebildet sein, dass er derart mit dem Rasthaken bzw. dessen Rastvorsprung zusammenwirkt, dass der Bauteilträger darin gehaltert wird, besonders vorteilhaft mit wenig Bewegungsspielraum nach oben oder nach unten, also im Wesentlichen lagesicher.

In vorteilhafter Ausgestaltung der Erfindung kann vorgesehen sein, dass eine Federwirkung bzw. eine Federkraft des Rastarms bzw. des Rastmittels entlang oder entgegen der Rastrichtung größer ist als in einer Richtung senkrecht dazu weg von der Halteeinrichtung bzw. hin zu ihr oder vertikal zur wesentlichen Fläche oder Ebene des Bauteils. Der Unterschied kann den Faktor 1,5 bis 5 betragen. Der Vorteil liegt darin, dass eine Federkraft des Rastarms entlang der Rastrichtung relativ groß sein sollte für eine sichere und stabile Halterung des Bauteilträgers daran. In der anderen Richtung vertikal zur Fläche des Bauteilträgers sollte eine Federkraft geringer sein, so dass das Rastmittel bzw. der Rastarm ohne allzu große Kraft in die vorbeschriebene Vertiefung hineingedrückt werden kann zum Ausweichen. Insbesondere liegt er dann ja auch mit im Wesentlichen dieser Kraft an der Unterseite des Bauteilträgers an, und auch deswegen sollte diese Kraft nicht zu groß sein.

Vorteilhaft weist eine Halteeinrichtung zwei Paare von Rastmitteln auf, wobei jeweils ein Paar von Rastmitteln für eine Größe einer Halteeinrichtung passend ausgebildet ist. Ein Paar kann also etwas kleinere Steuerungen haltern und das andere Paar etwas größere Steuerungen. Die beiden Rastmittel jedes dieser Paare weisen einen seitlichen Abstand zueinander auf. Vorteilhaft können sie von einem gemeinsamen Bereich aus voneinander weglaufen. Ist die Steuerung bzw. der Bauteilträger eher klein, dann wird der Bauteilträger von dem näher an den vorgenannten Haltevorsprüngen liegenden Rastmitteln gehalten in deren Rastposition mit Übergreifen des Bauteilträgers durch deren Rastvorsprünge. Ist die Steuerung bzw. deren Bauteilträger eher groß, dann werden die vorgenannten Rastmittel für den kleineren Bauteilträger aus der Ausgangsposition nach unten in die Vertiefungen in die Tiefposition gedrückt und stören somit nicht mehr, während der Bauteilträger an den anderen Rastmitteln in deren Rastposition festgerastet wird.

Die Halteeinrichtung kann die Steuerung an dem Elektrogerät in im Wesentlichen beliebiger vorgegebener Position haltern. Vorteilhaft weist die Steuerung Bedienelemente auf, die an bzw. unter einer Bedienfläche liegen sollten. In diesem Fall ist die Steuerung unter einer Bedienfläche des Elektrogeräts gehaltert.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig.1: eine Schrägansicht auf eine erfindungsgemäße Halteeinrichtung an einer Grundplatte für eine Steuerung eines Elektrokochfelds,
- Fig. 2: eine Vergrößerung der Halteeinrichtung aus Fig. 1,
- Fig. 3: eine geschnittene Seitenansicht eines kompletten Elektrokochfelds mit einer kleinen Steuerung an der Halteeinrichtung,
- Fig. 4: eine Vergrößerung der Schnittdarstellung aus Fig. 3 mit der kleinen Steuerung an der Halteeinrichtung,
- Fig. 5: eine Draufsicht auf die Anordnung der kleinen Steuerung an der Halteeinrichtung entsprechend Fig. 3 und 4,
- Fig. 6: eine Abwandlung der Fig. 4 mit einer großen Steuerung an der Halteeinrichtung und
- Fig. 7: eine Draufsicht entsprechend Fig. 5 auf die Fig. 6.

### Detaillierte Beschreibung der Ausführungsbeispiele

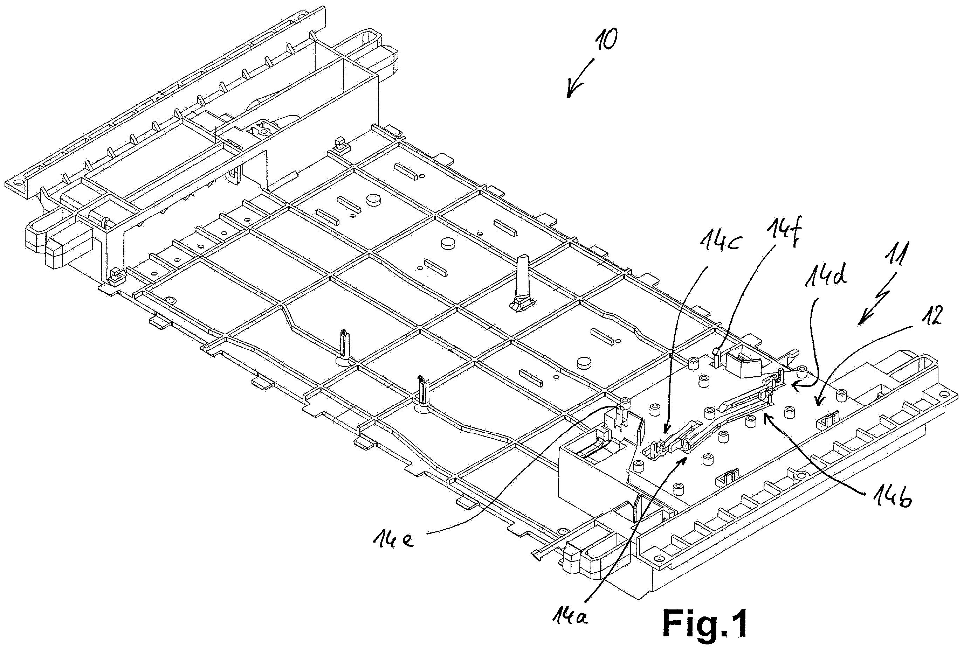

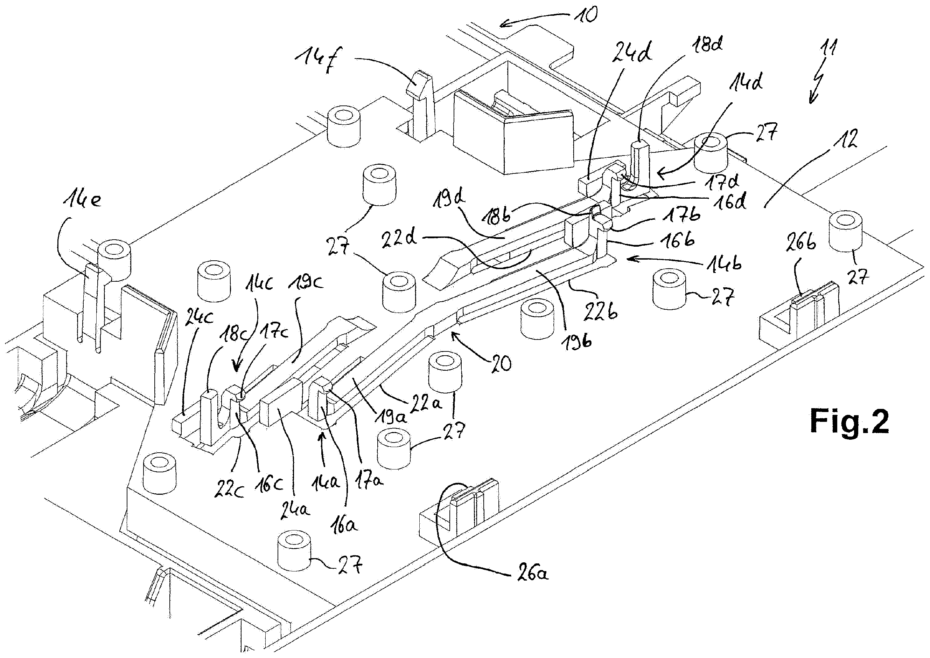

In Fig. 1 und 2 ist dargestellt, wie an einer Grundplatte 10 für den Aufbau eines Elektrokochfelds, wie sie aus der deutschen Patentanmeldung DE 102012217059.6 mit Anmeldetag vom 21. September 2012 derselben Anmelderin bekannt ist, in einem Bereich, der später bei einem Elektrokochfeld vorne angeordnet sein soll, eine Halteeinrichtung 11 mit einer erhöht ausgebildeten Halteplatte 12 vorgesehen ist. Die gesamte Grundplatte 10 ist ein Kunststoff-Spritzgussteil samt sämtlichen, daran vorgesehenen Vorrichtungen, vorteilhaft ist sie in einem Arbeitsgang einstückig hergestellt..

An der Halteplatte 12 sind vier Rastmittel 14a bis 14d vorgesehen, die grundsätzlich ähnlich aufgebaut sind. Die Rastmittel 14a bis 14d weisen am freien, bewegbaren Ende einen Rasthaken 16a bis 16d auf, der an seinem oberen Ende einen Rastvorsprung 17a bis 17d trägt. Die Rasthaken 16a bis 16d sind an Rastarmen 19a bis 19d angeformt. Die beiden vorderen Rastmittel 14a und 14b gehen dabei mit ihren Rastarmen 19a und 19b von einem gemeinsamen Verbindungsbereich 20 ab, wie eingangs als Möglichkeit genannt worden ist. Des Weiteren bilden die Rastmittel 14a und 14b einen Teil einer Halterung für eine kleine Steuerung, während die Rastmittel 14c und 14d für eine große Steuerung vorgesehen sind. Dies wird nachfolgend noch näher erläutert.

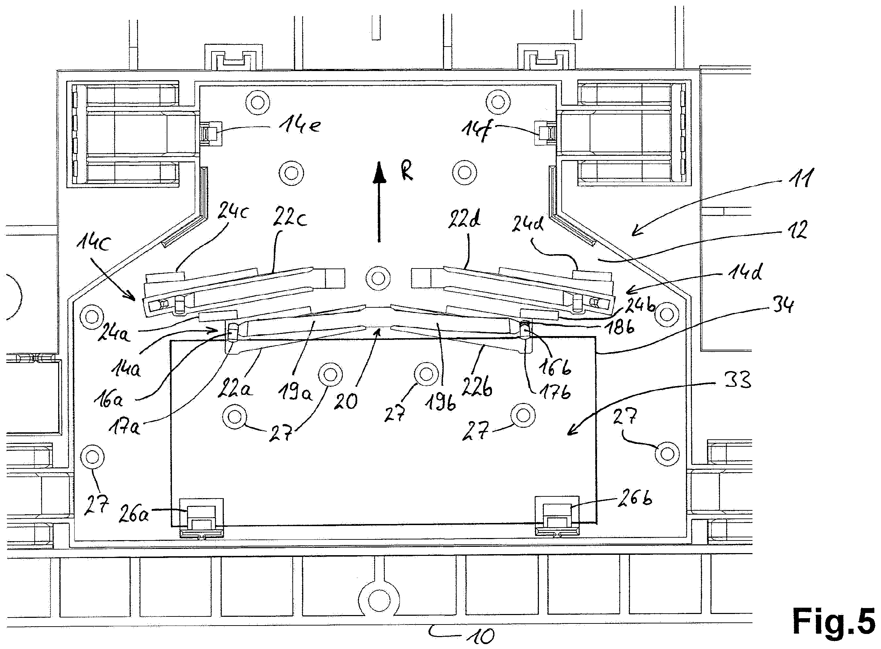

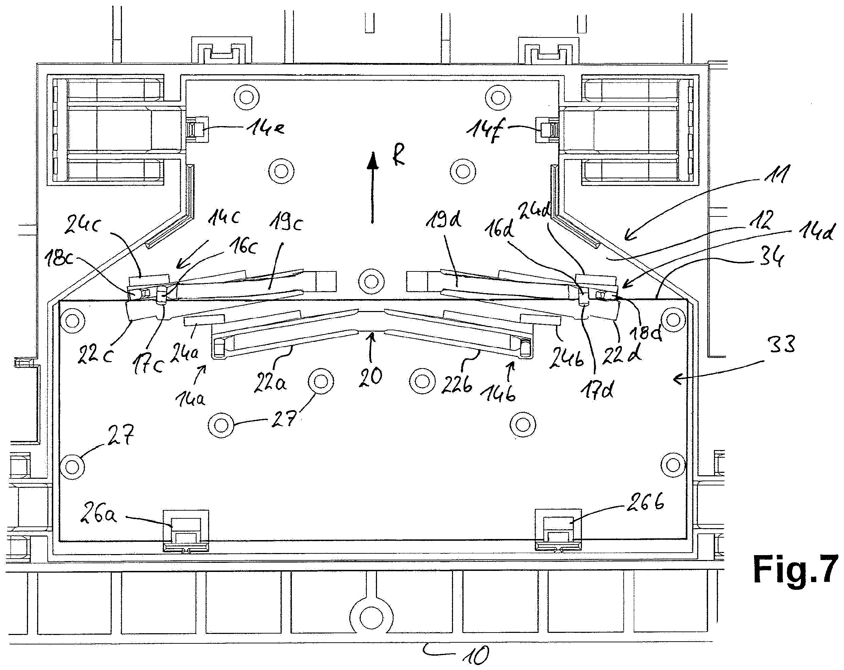

Unter den Rastmitteln 14a bis 14d sind Vertiefungen 22a bis 22d, die, wie auch aus der Draufsicht der Fig. 5 und 7 deutlich wird, von der Kontur her etwas größer ausgebildet sind als die Kontur der Rastmittel 14a bis 14d selbst. Die Vertiefungen können vollständig durch die Halteplatte 12 hindurchgehen. Wichtig ist jedenfalls, dass die jeweiligen Rastmittel 14d ausreichend tief in sie hinuntergedrückt werden können, insbesondere mit den Rasthaken 16a bis 16d. Es ist auch zu erkennen, dass die Vertiefungen 22a bis 22d gleichzeitig eine Art Freischnitt für die Rastarme 19a bis 19d von der Halteplatte 12 sind.

An dem Rasthaken 16b ist oben am Rastvorsprung 17b eine nach oben stehende Nase 18b angeformt. Sie kann dazu dienen, das Rastmittel 16b nach hinten zu biegen oder weiter nach unten zu drücken. In ähnlicher Form sind an den Rasthaken 16c und 16d Vorsprünge 18c und 18d angeordnet. Diese stehen noch weiter außen als die Rasthaken 16c und 16d und überragen sie nach oben. Sie können als seitliche Halterung für eine an der Halteeinrichtung 11 festgerastete Steuerung dienen, alternativ zu einem leichteren Biegen der Rastarme 19c und 19d nach hinten.

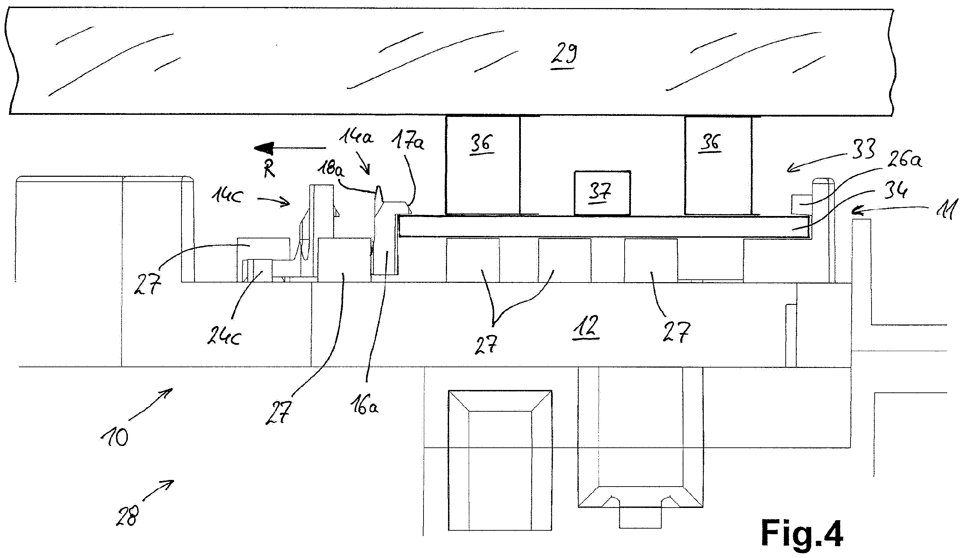

Es ist leicht zu erkennen, wie nachfolgend auch die Fig. 5 und 7 verdeutlichen, dass die Rastmittel 14a und 14b für eine kleine Steuerung und die Rastmittel 14c und 14d für eine größere Steuerung ausgebildet sind. Jeweils eine Seitenkante bzw. Außenkante einer Steuerung oder eines Bauteilträgers der Steuerung kann daran festgerastet werden. Die gegenüberliegende Seite wird an zwei Haltevorsprüngen 26a und 26b an der Halteplatte 12 befestigt bzw. eingerastet, wie vor allem auch aus der Fig. 4 zu ersehen ist.

Des Weiteren sind an der Halteplatte 12 noch zwei Rasthaken 14e und 14f vorgesehen, und zwar in einem schmäleren Erstreckungsbereich der Halteplatte 12. Diese sind konventionell ausgebildet und ermöglichen zusammen mit den Haltevorsprüngen 26a und 26b die Befestigung einer sehr großen Steuerung, deren Grundform im Wesentlichen der Gesamtfläche der Halteplatte 12 entspricht. Dabei können alle vier Rastmittel 14a bis 14d nach unten in die Vertiefungen 22a bis 22d ausweichen.

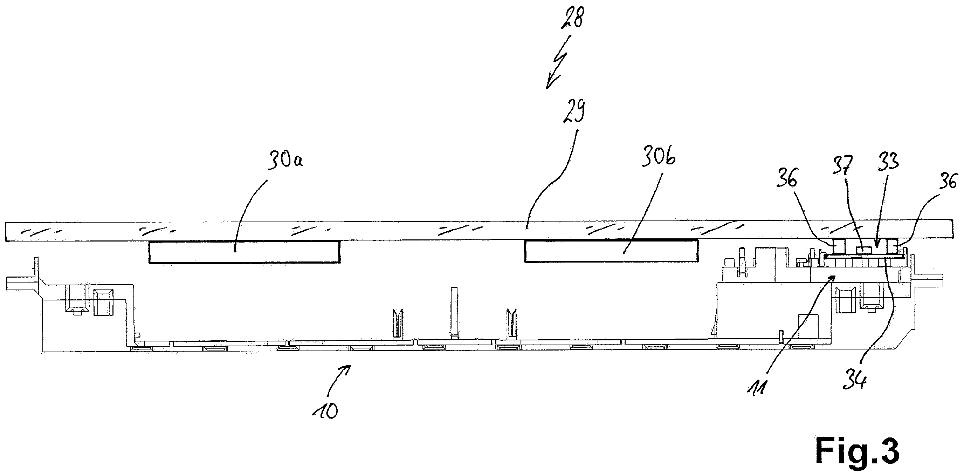

In der Schnittdarstellung der Fig. 3 ist ein gesamtes Induktionskochfeld als Elektrokochfeld 28 bzw. als Elektrogerät dargestellt. Es weist eine Kochfeldplatte 29 und zwei darunter angeordnete Induktionsheizeinrichtungen 30a und 30b auf. Im rechten Bereich ist an der Halteeinrichtung 11 eine Steuerung 33 gehaltert mit einer Leiterplatte 34 als Bauteilträger. Die Leiterplatte 34 trägt zwei symbolisch dargestellte kapazitive Sensorelemente 36, die an die Unterseite der Kochfeldplatte 29 angelegt sind. Diese können ausgebildet sein wie aus der EP 859467 A bekannt. Des Weiteren trägt sie ein schematisch dargestelltes Bauteil 37, beispielsweise eine Leuchtanzeige oder ein Schaltungsbauteil.

Aus der Vergrößerung der Fig. 4 ist zu ersehen, dass die Steuerung 33 mit der Leiterplatte 34 an der Halteeinrichtung 11 bzw. an der Halteplatte 12 gehalten ist, und zwar, wie auch die Draufsicht der Fig. 5 hierzu deutlich macht, mit der rechts dargestellten langen Seitenkante an den Haltevorsprüngen 26a und 26b. Die andere lange Seitenkante ist an den Rastmitteln 14a und 14b bzw. Rasthaken 16a und 16b samt Rastvorsprüngen 17a und 17d gehalten, und zwar an den durch die Federkraft der entsprechend der Draufsicht in Fig. 5 etwas gespannten Rastmittel 14a und 14b bzw. deren Rastarme 19a und 19b. Nach unten liegt sie auf den Abstandshaltern 27, und nach oben ist sie durch die Rastvorsprünge 17a und 17b sowie eben die Haltevorsprünge 26a und 26b gehalten. Gemäß Fig. 5 ist zu ersehen, dass eine Halterung der Steuerung 33 bzw. der Leiterplatte 34 quer zur eingangs genannten Rastrichtung R der Rastmittel 14a bis 14d nicht direkt mit einem starren oder federnden Anschlag vorgesehen ist. Hier genügt dann die Reibung an den Rastvorsprüngen 17a und 17b, an den Haltevorsprüngen 26a und 26b sowie durch das Aufliegen auf den Abstandshaltern 27.

Aus der Draufsicht der Fig. 5 ist zu ersehen, dass die Rastarme 19a und 19b der Rastmittel 14a und 14b einige Millimeter nach hinten gebogen sind bzw. weg von den Haltevorsprüngen 26a und 26b, also in der Rastrichtung R. Damit können zum einen bestimmte Größenbereiche der Leiterplatte 34 der Steuerung 33 noch abgedeckt werden zur guten Halterung. Des Weiteren wird die Halterung der Leiterplatte 34 durch die dadurch entstehende Federkraft verbessert. Es ist auch zu ersehen, dass die Rastarme 19a und 19b in ihrer Rastposition nicht mehr über ihren Vertiefungen 22a und 22b verlaufen. Somit können sie nicht mehr nach unten gedrückt werden, wodurch wiederum eine verbesserte Halterung der Leiterplatte 34 möglich ist. Schließlich können so die Sensorelemente 36 mit ausreichend Kraft an die Unterseite der Kochfeldplatte 29 gedrückt werden. Insbesondere ist hier veranschaulicht, dass die Rastmittel 14a und 14b mit ihren Rasthaken 16a und 16b fast an den entsprechenden zugehörigen Anschlägen 24a und 24b anliegen. Die Rastmittel 14c und 14d sind in diesem Fall gar nicht betroffen und auch nicht im Einsatz und somit in ihrer Ausgangsposition. Des Weiteren ist aus der Draufsicht der Fig. 5 zu ersehen, dass entlang einer gedachten Mittellinie der Steuerung 33, die parallel zur Rastrichtung R verläuft, die Rastmittel 14a und 14c symmetrisch angeordnet und weitgehend symmetrisch ausgebildet sind zu den Rastmitteln 14b und 14d.

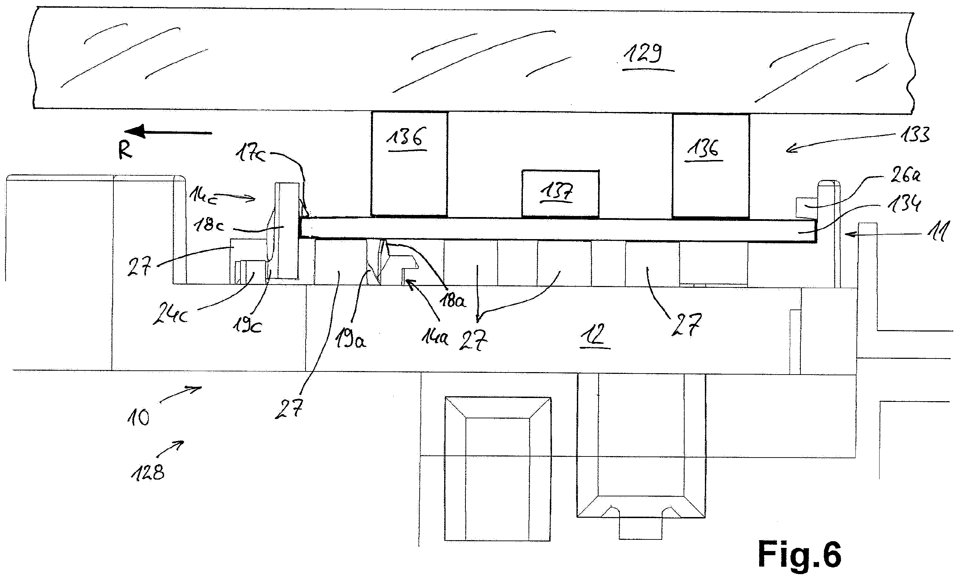

In den Fig. 6 und 7 ist eine größere Steuerung 133 mit ihrer Leiterplatte 134 unter einer Kochfeldplatte 129 eines Elektrokochfelds 128 angeordnet. Die Steuerung 133 weist wiederum kapazitive Sensorelemente 136 und ein Bauteil 137 auf der Leiterplatte 134 auf. Es ist zu ersehen, dass die Leiterplatte 134 mit ihrer hinteren langen Seitenkante an den hinteren Rastmitteln 14c und 14d befestigt ist bzw. von diesen gehalten wird. Dabei sind diese, ähnlich wie schon in der Fig. 5 die vorderen Rastmittel 14a und 14b, in Rastrichtung nach hinten gebogen bis kurz vor die entsprechenden Anschläge 24c und 24d in die Rastposition. Die andere lange Seitenkante der Leiterplatte 134 ist unter den Haltevorsprüngen 26a und 26b gehalten.

Aus der seitlichen Darstellung der Fig. 6 wird deutlich, dass die vorderen Rastmittel 14a und 14b in die Tiefposition nach unten gedrückt sind in die Vertiefungen 22a und 22b, welche in der Fig. 6 nicht zu erkennen sind. Dies kann beim Einsetzen der Leiterplatte 134 erfolgen, wenn diese mit der vorderen langen Seitenkante unter die Haltevorsprünge 26a und 26b geführt wird und dann in einer Schwenkbewegung von oben gegen die Halteplatte 12 gedrückt wird. Dabei können die hinteren Rastmittel 14c und 14d mit den vorbeschriebenen Vorsprüngen 18c und 18d nach hinten gebogen werden, um das Herunterdrücken der Leiterplatte 134 zu erleichtern, bis diese auf den Abstandshaltern 27 aufliegt. Dann werden die Rasthaken 16c und 16d wieder freigelassen und rasten in der Rastposition mit den Rastvorsprüngen 17c und 17d über der Leiterplatte 134 ein zu deren Halterung.

Eingangs ist erläutert worden, dass eine Federkraft der Rastarme 19a bis 19d in einer Richtung auf die Halteplatte 12 zu oder von dieser weg geringer sein sollte als entlang der Rastrichtung R. Dies kann vorteilhaft durch entsprechende Querschnitte der Rastarme 19a bis 19d erreicht werden, wie es die Fig. 2 gut zeigt. Sie sind nämlich erheblich flacher als breit, so dass die von ihnen aufgebrachte elastische Federkraft entlang der Rastrichtung R bzw. parallel zur Ebene der Halteplatte 12 oder der Leiterplatte 34 deutlich größer ist als in der Richtung senkrecht dazu. So können sie zwar eine Steuerung 33 gegen Abheben von der Halteplatte 12 weniger gut haltern. Dies ist im montierten Zustand des Elektrokochfelds 28 aber auch nicht möglich, da ja die Sensorelemente 36 gegen die Unterseite der Kochfeldplatte 29 gedrückt sind.

## Patentansprüche

1. Halteeinrichtung (11) für eine Steuerung (33, 133) mit einem Bauteilträger (34, 134), die an der Halteeinrichtung formschlüssig befestigt ist mittels des Bauteilträgers, wobei die Halteeinrichtung (11) eine Halteplatte (12) oder einen Haltekörper aufweist und wobei daran mindestens zwei unterschiedliche Rastmittel (14a-d) zum Festrasten bzw. federnden Übergreifen des Bauteilträgers (34, 134) vorgesehen sind, wobei die mindestens zwei unterschiedlichen Rastmittel (14a-d) für unterschiedlich große Bauteilträger (34, 134) der Steuerungen (33, 133) ausgebildet sind, **dadurch gekennzeichnet, dass** ein Rastmittel (14a-d) einen Rasthaken (16a-d) mit einem Rastvorsprung (17a-d) aufweist und an einem langen Rastarm (19a-d) angeordnet ist, wobei die Rastmittel eine Rastrichtung aufweisen, entlang derer sie zurückweichen beim Festrasten des Bauteilträgers und wobei ein Rastarm (19a-d) mit einem Winkel von 90° bis 60° zu dieser Rastrichtung verläuft, wobei in einer Ausgangsposition des Rastmittels (14a-d) vor Ansetzen des Bauteilträgers (34, 134) unter dem Rastmittel eine Vertiefung (22a-d) vorgesehen ist zum Ausweichen des Rastarms (19a-d) und des Rasthakens (16a-d) in diese Vertiefung (22a-d) hinein.

2. Halteeinrichtung nach Anspruch 1, **dadurch gekennzeichnet, dass** in der Rastrichtung gesehen mindestens zwei Rastmittel (14a-d) mit Abstand entlang der Rastrichtung vorgesehen sind, vorzugsweise mit Abstand zueinander und insbesondere versetzt zueinander.

3. Halteeinrichtung nach Anspruch 1 oder 2, **dadurch gekennzeichnet, dass** entlang der Rastrichtung mit seitlichem Abstand zueinander mindestens zwei Rastmittel (14a-d) auf etwa gleicher Höhe entlang der Rastrichtung vorgesehen sind, wobei vorzugsweise die beiden Rastmittel jeweils näher an einer seitlichen Außenkante des Bauteilträgers (34, 134) oder des Haltekörpers angeordnet sind als an einer Mittellinie des Haltekörpers entlang der Rastrichtung.

4. Halteeinrichtung nach Anspruch 3, **dadurch gekennzeichnet, dass** mindestens zwei Rastarme (19a-d) mit Rasthaken (16a-d), die entlang der Rastrichtung auf gleicher Höhe angeordnet sind, von einem gemeinsamen Bereich (20) aus weg gehen, wobei insbesondere der gemeinsame Bereich in etwa auf einer Mittellängsachse des Bauteilträgers (34, 134) entlang der Rastrichtung liegt.

5. Halteeinrichtung nach einem der vorhergehenden Ansprüche, **dadurch gekennzeichnet, dass** mit Abstand zu den Rastmitteln (14a-d) entlang der Rastrichtung mindestens ein Haltevorsprung (26a, b) vorgesehen ist zur Halterung der Steuerung (33, 133) bzw. des Bauteilträgers (34, 134) entlang der Rastrichtung gegen eine Bewegung weg von den Rastmitteln und gegen eine Bewegung senkrecht zur Fläche des Bauteilträgers (34, 134) weg von der Halteeinrichtung (11).

6. Halteeinrichtung nach einem der vorhergehenden Ansprüche, **dadurch gekennzeichnet, dass** sich die Vertiefungen (22a-d) unter den Rastmitteln (14a-d) über die gesamte freigelegte bzw. frei bewegbare Länge der Rastarme (19a-d) erstrecken.

7. Halteeinrichtung nach einem der vorhergehenden Ansprüche, **dadurch gekennzeichnet, dass** die Vertiefungen (22a-d) unter den Rastarmen (19a-d) nur unwesentlich breiter sind als die Rastarme selbst, vorzugsweise um etwa 5% bis maximal 25%, wobei vorzugsweise eine Vertiefung (22a-d) der Kontur eines Rastarms (19a-d) samt Rasthaken (16a-d) von oben entspricht mit 5% bis maximal 25% Vergrößerung.

8. Halteeinrichtung nach einem der vorhergehenden Ansprüche, **dadurch gekennzeichnet, dass** in Rastrichtung gesehen weg von dem Bauteilträger (34, 134) auf einem Haltekörper ein Anschlag (24a-d) angeordnet ist zur Begrenzung einer Bewegung des Rastmittels (14a-d) bzw. des Rasthakens (16a-d) in Rastrichtung weg von dem Bauteilträger, wobei vorzugsweise der Anschlag (24a-d) wenige Millimeter neben der Vertiefung (22a-d) in Rastrichtung gesehen angeordnet ist.

9. Halteeinrichtung nach einem der vorhergehenden Ansprüche, **dadurch gekennzeichnet, dass** an dem Rasthaken (16a-d) mit etwas Abstand unter dem Rastvorsprung (17a-d), vorzugsweise 1mm bis 3mm Abstand, ein Abstützvorsprung am Rasthaken bzw. am Rastarm vorgesehen ist zur Anordnung des Bauteilträgers (34, 134) derart zwischen Rasthaken und Abstützvorsprung, dass er dort halterbar ist.

10. Halteeinrichtung nach einem der vorhergehenden Ansprüche, **dadurch gekennzeichnet, dass** eine Federwirkung bzw. eine Federkraft des Rastarms (19a-d) entlang der Rastrichtung größer ist als in einer Richtung senkrecht dazu weg von der Halteeinrichtung (11) bzw. vertikal zur Fläche des Bauteilträgers (34, 134), vorzugsweise mindestens 1,5 mal bis 5 mal so groß.

11. Elektrogerät mit einer Halteeinrichtung (11) nach einem der vorhergehenden Ansprüche und mit einer Steuerung (33, 133) mit einem Bauteilträger (34, 134) für Steuerungsbauteile (36, 37, 136, 137), wobei der Bauteilträger durch mindestens eines von mindestens zwei Rastmitteln (14a-d) an der Halteeinrichtung (11) gehalten ist, die in Rastrichtung einander entsprechen.

12. Elektrogerät nach Anspruch 11, **dadurch gekennzeichnet, dass** das Rastmittel (14a-d) mit dem Rasthaken (16a-d) mit dem Rastarm (19a-d) von der Ausgangsposition über den Vertiefungen (22a-d) in Rastrichtung durch den Bauteilträger (34, 134) weg gedrückt ist von der Vertiefung, wobei vorzugsweise ein Bereich eines Haltekörpers der Halteeinrichtung (11) unter dem Rasthaken (16a-d) bzw. unter einem Bereich des Rastarms (19a-d) nahe an dem Rasthaken verläuft zur Abstützung des Rasthakens (16a-d) in diese Richtung.

13. Elektrogerät nach Anspruch 11 oder 12, **dadurch gekennzeichnet, dass** der Bauteilträger mindestens ein Rastmittel (14a-d) vollständig überdeckt ohne rastende Halterung daran, wobei das Rastmittel durch den Bauteilträger (34, 134) ausgehend von der Ausgangsposition in eine darunter verlaufende Vertiefung (22a-d) eingedrückt ist und durch ein in Rastrichtung etwas weiter entferntes Rastmittel an der Halteeinrichtung (11) gehalten ist.

## Claims

1. Holding device (11) for a control (33, 133) with a component carrier (34, 134), which control is fixed to the holding device in a form-fitting manner by means of the component carrier, wherein the holding device (11) includes a holding plate (12) or a holding body, and wherein at least two different snap means (14a-d) for snap-fixing or resilient overlapping of the component carrier (34, 134) are provided thereon, wherein the at least two different snap means (14a-d) are configured for component carriers (34, 134) in different sizes of the controls (33, 133),
**characterized in that**
a snap means (14a-d) includes a snap hook (16a-d) with a snap protrusion (17a-d) and is disposed on a long snap arm (19a-d), wherein the snap means have a snap direction, along which they retreat during snap-fixing of the component carrier, and wherein a snap arm (19a-d) extends with an angle of 90° to 60° relative to said snap direction, wherein in an initial position of said snap means (14a-d), prior to attaching the component carrier (34, 134), a recess (22a-d) is provided under the snap means for turning the snap arm (19a-d) and the snap hook (16a-d) into said recess (22a-d).

2. Holding device according to claim 1, **characterized in that**, as seen in the snap direction, at least two snap means (14a-d) are provided and spaced along the snap direction, preferably with a distance to each other, and in particular offset to each other.

3. Holding device according to claim 1 or 2, **characterized in that** at least two snap means (14a-d) are provided along the snap direction with a lateral distance to each other and approximately on a same level along the snap direction, wherein preferably the two snap means are respectively located closer to a lateral outer edge of the component carrier (34, 134) or the holding body than to a central line of the holding body along the snap direction.

4. Holding device according to claim 3, **characterized in that** at least two snap arms (19a-d) with snap hooks (16a-d), disposed along the snap direction on the same level, start out from a common region (20), wherein in particular the common region is located approximately on a central longitudinal axis of the component carrier (34, 134) along the snap direction.

5. Holding device according to any of the preceding claims, **characterized in that** at least one holding protrusion (26a, b) is provided spaced to the snap means (14a-d) along the snap direction for holding the control (33, 133) and/or the component carrier (34, 134) along the snap direction to prevent movement away from the snap means and to prevent movement perpendicular to the surface of the component carrier (34, 134) away from the holding device (11).

6. Holding device according to any of the preceding claims, **characterized in that** the recesses (22a-d) under the snap means (14a-d) extend across the entire exposed or freely movable length of the snap arms (19a-d).

7. Holding device according to any of the preceding claims, **characterized in that** the recesses (22a-d) under the snap arms (19a-d) are only insignificantly wider than the snap arms per se, preferably by approximately 5 % to a maximum of 25 %, wherein preferably a recess (22a-d) corresponds to the contour of a snap arm (19a-d) together with snap hook (16a-d) from above, with an enlargement of 5 % to a maximum of 25 %.

8. Holding device according to any of the preceding claims, **characterized in that** a stop (24a-d) is disposed on a holding body, as seen in the snap direction away from the component carrier (34, 134), for limiting movement of the snap means (14a-d) and/or the snap hook (16a-d) in the snap direction away from the component carrier, wherein preferably the stop (24a-d) is disposed a few millimeters besides the recess (22a-d), as seen in the snap direction.

9. Holding device according to any of the preceding claims, **characterized in that** on the snap hook (16a-d) with some distance under the snap protrusion (17a-d), preferably a distance of 1 mm to 3 mm, a support protrusion is provided on the snap hook and/or on the snap arm for arranging the component carrier (34, 134) between snap hook and support protrusion such that it can be held there.

10. Holding device according to any of the preceding claims, **characterized in that** a spring effect or a spring force of the snap arm (19a-d) along the snap direction is greater than in a direction perpendicular thereto away from the holding device (11) and/or vertical to the surface of the component carrier (34, 134), preferably at least 1.5 times to 5 times as great.

11. Electric device comprising a holding device (11) according to any of the preceding claims, and comprising a control (33, 133) with a component carrier (34, 134) for control components (36, 37, 136, 137), wherein the component carrier is held on the holding device (11) by at least one of at least two snap means (14a-d) which correspond to each other in the snap direction.

12. Electric device according to claim 11, **characterized in that** the snap means (14a-d) with the snap hook (16a-d) with the snap arm (19a-d) is pushed away from the recess from the initial position above the recesses (22a-d) in the snap direction by the component carrier (34, 134), wherein preferably a region of a holding body of the holding device (11) extends under the snap hook (16a-d) and/or under a region of the snap arm (19a-d) close to the snap hook for supporting the snap hook (16a-d) in this direction.

13. Electric device according to claim 11 or 12, **characterized in that** the component carrier covers at least one snap means (14a-d) completely without a snapping holder thereon, wherein the snap means is pushed into a recess (22a-d) extending thereunder by the component carrier (34, 134) starting from the initial position and is held on the holding device (11) by a snap means located somewhat further remote in the snap direction.

## Revendications

1. Dispositif (11) de maintien d'une commande (33, 133), présentant un porte-composant (34, 134), la commande étant fixée en correspondance géométrique sur le dispositif de maintien au moyen du porte-composant, le dispositif (11) de maintien présentant une plaque de maintien (12) ou un corps de maintien, au moins deux moyens d'encliquetage différents (14a-d) qui fixent le porte-composant (34, 134) par encliquetage ou par chevauchement élastique étant prévus sur ces derniers, les deux ou plusieurs moyens d'encliquetage différents (14a-d) étant configurés pour différentes tailles de porte-composant (34, 134) des commandes (33, 133), **caractérisé en ce que**
un moyen d'encliquetage (14a-d) présente un crochet d'encliquetage (16a-d) doté d'une saillie d'encliquetage (17a-d) et est disposé sur un long bras d'encliquetage (19a-d),
**en ce que** les moyens d'encliquetage présentent une direction d'encliquetage le long de laquelle ils se rétractent lors de la fixation du porte-composant par encliquetage,
**en ce qu'**un bras d'encliquetage (19a-d) forme un angle de 90° à 60° par rapport à cette direction d'encliquetage,
**en ce qu'**un creux (22a-d) est prévu dans une position initiale du moyen d'encliquetage (14a-d) avant le placement du porte-composant (34, 134) en dessous du moyen d'encliquetage pour permettre le déploiement du bras d'encliquetage (19a-d) et du crochet d'encliquetage (16a-d) dans ce creux (22a-d).

2. Dispositif de maintien selon la revendication 1, **caractérisé en ce que** dans la direction d'encliquetage, au moins deux moyens d'encliquetage (14a-d) sont prévus à distance mutuelle dans la direction d'encliquetage, de préférence à une distance mutuelle et en particulier à un décalage mutuel.

3. Dispositif de maintien selon les revendications 1 ou 2, **caractérisé en ce qu'**au moins deux moyens d'encliquetage (14a-d) sont prévus à sensiblement la même hauteur dans la direction d'encliquetage, à un écart latéral mutuel dans la direction d'encliquetage, de préférence les deux moyens d'encliquetage étant chacun disposés plus près d'un bord latéral extérieur du porte-composant (34, 134) ou du corps de maintien que d'une ligne centrale du corps de maintien dans la direction d'encliquetage.

4. Dispositif de maintien selon la revendication 3, **caractérisé en ce qu'**au moins deux bras d'encliquetage (19a-d) dotés de crochets d'encliquetage (16a-d) disposés à même hauteur dans la direction d'encliquetage s'éloignent d'une partie commune (20), la partie commune étant située sensiblement sur l'axe longitudinal central du porte-composant (34, 134) dans la direction d'encliquetage.

5. Dispositif de maintien selon l'une des revendications précédentes, **caractérisé en ce qu'**à distance des moyens d'encliquetage (14a-d), au moins une saillie de maintien (26a, b) est prévue dans la direction d'encliquetage pour maintenir la commande (33, 133) ou le porte-composant (34, 134) dans la direction d'encliquetage pour l'empêcher de s'écarter des moyens d'encliquetage et de se déplacer perpendiculairement à la surface du porte-composant (34, 134) pour s'éloigner du dispositif de maintien (11).

6. Dispositif de maintien selon l'une des revendications précédentes, **caractérisé en ce que** les creux (22a-d) s'étendent en dessous des moyens d'encliquetage (14a-d) sur toute la longueur libre ou librement déplaçable des bras d'encliquetage (19a-d).

7. Dispositif de maintien selon l'une des revendications précédentes, **caractérisé en ce qu'**en dessous des bras d'encliquetage (19a-d), les creux (22a-d) ne sont que légèrement plus larges que les bras d'encliquetage proprement dits, de préférence d'environ 5 % à au plus 25 %, un creux (22a-d) correspondant de préférence au contour d'un bras d'encliquetage (19a-d), y compris son crochet d'encliquetage (16a-d) par le haut, avec un agrandissement de 5 % à au plus 25 %.

8. Dispositif de maintien selon l'une des revendications précédentes, **caractérisé en ce qu'**à distance du porte-composant (34, 134) dans la direction d'encliquetage, une butée (24a-d) est disposée sur un corps de maintien pour limiter un déplacement d'éloignement du moyen d'encliquetage (14a-d) ou du crochet d'encliquetage (16a-d) dans la direction d'encliquetage par rapport au porte-composant, la butée (24a-d) étant de préférence disposée à quelques millimètres à côté du creux (22a-d) dans la direction d'encliquetage.

9. Dispositif de maintien selon l'une des revendications précédentes, **caractérisé en ce que** sur le crochet d'encliquetage (16a-d), à une certaine distance en dessous de la saillie d'encliquetage (17ad), à une distance de préférence de 1 mm à 3 mm, une saillie de soutien est prévue sur le crochet d'encliquetage ou sur le bras d'encliquetage pour disposer le porte-composant (34, 134) entre le crochet d'encliquetage et la saillie de soutien pour qu'il puisse y être maintenu.

10. Dispositif de maintien selon l'une des revendications précédentes, **caractérisé en ce qu'**un effet élastique ou une force élastique du bras d'encliquetage (19a-d) dans la direction d'encliquetage est plus grande que dans une direction perpendiculaire s'éloignant du dispositif de maintien (11) ou verticalement par rapport à la surface du porte-composant (34, 134), et de préférence au moins 1,5 à 5 fois plus grande.

11. Appareil électrique doté d'un dispositif (11) de maintien selon l'une des revendications précédentes et d'une commande (33, 133), avec un porte-composant (34, 134) pour des composants (36, 37, 136, 137) de la commande, le porte-composant étant maintenu sur le dispositif (11) de maintien par au moins l'un d'au moins deux moyens d'encliquetage (14a-d) qui se correspondent mutuellement dans la direction d'encliquetage.

12. Appareil électrique selon la revendication 11, **caractérisé en ce que** le moyen d'encliquetage (14a-d) avec le crochet d'encliquetage (16a-d) est repoussé par le bras d'encliquetage (19a-d) depuis la position initiale au-dessus des creux (22a-d) dans la direction d'encliquetage par le porte-composant (34, 134) de manière à s'éloigner du creux, de préférence une partie d'un corps de maintien du dispositif (11) de maintien s'étendant en dessous du crochet d'encliquetage (16ad) ou en dessous d'une partie du bras d'encliquetage (19a-d) à proximité du crochet d'encliquetage, pour soutenir le crochet d'encliquetage (16a-d) dans cette direction.

13. Appareil électrique selon les revendications 11 ou 12, **caractérisé en ce que** le porte-composant recouvre complètement au moins un moyen d'encliquetage (14a-d) sans y être maintenu par encliquetage, le moyen d'encliquetage étant enfoncé par le porte-composant (34, 134), partant de la position initiale, dans un creux (22a-d) situé en dessous et est maintenu sur le dispositif (11) de maintien par un moyen d'encliquetage un peu plus éloigné dans la direction d'encliquetage.
